Europäisches Patentamt

(19) European Patent Office

Office européen des brevets

(11) Veröffentlichungsnummer: **0 213 556**
**A2**

(12) **EUROPÄISCHE PATENTANMELDUNG**

(21) Anmeldenummer: 86111560.8

(51) Int. Cl.⁴: **C 23 C 14/56**

(22) Anmeldetag: 21.08.86

(30) Priorität: 23.08.85 DE 3530106

(43) Veröffentlichungstag der Anmeldung:
11.03.87 Patentblatt 87/11

(84) Benannte Vertragsstaaten:
DE FR GB IT

(71) Anmelder: Elektroschmelzwerk Kempten GmbH
Herzog-Wilhelm-Strasse 16
D-8000 München 2(DE)

(72) Erfinder: de Rudnay, André, Dr.
16, Chemin de Renens Château de Valency
CH-1004 Lausanne(CH)

(54) Vorrichtung für das Aufdampfen von anorganischen Verbindungen mittels einer Photonen-erzeugenden thermischen Strahlungsheizquelle in kontinuierlich betriebenen Vakuumbedampfungsanlagen.

(57) Gegenstand der Erfindung ist eine Vorrichtung für das Aufdampfen von anorganischen Verbindungen mittels einer Photonenerzeugenden thermischen Strahlungsheizquelle in kontinuierlich betriebenen Vakuumbedampfungsanlagen. Die Vorrichtung besteht aus dem Aufdampfgut, das aus pulverförmigen anorganischen Verbindungen mit Schmelzpunkten > 1000°C, gegebenenfalls im Gemisch mit Elementen mit Schmelzpunkten > 1000°C durch Vermischen unter Formgebung hergestellt worden ist und aus der thermischen Strahlungsheizquelle, wobei Aufdampfgut und thermische Strahlungsheizquelle kontaktlos verbunden sind. Das Aufdampfgut ist als mindestens ein vorzugsweise poröser Festkörper ausgebildet und Festkörper und/oder thermische Strahlungsheizquelle sind beweglich angeordnet. Die Bewegung des Aufdampfgutes kann dadurch bewerkstelligt werden, daß dieses entweder auf einem Träger beweglich angeordnet oder mit einem beweglich angeordneten Träger verbunden ist, derart, daß der unbeweglich angeordneten thermischen Strahlungsheizquelle kontinuierlich unverbrauchtes Aufdampfgut nachgeliefert wird. Mit Hilfe dieser Vorrichtung können beliebige Substrate insbesondere Folien in kontinuierlichen Vakuumbedampfungsanlagen mit hochschmelzenden anorganischen Verbindungen durch einfaches oder reaktives Aufdampfen mit hoher Aufdampfrate gleichmäßig beschichtet werden.

Fig. 1

ELEKTROSCHMELZWERK KEMPTEN
GMBH

München, den 18.06.1986
Dr.Wg/rei

0213556

Es 8403
=======

Vorrichtung für das Aufdampfen von anorganischen
Verbindungen mittels einer Photonen-erzeugenden
thermischen Strahlungsheizquelle in kontinuierlich betriebenen Vakuumbedampfungsanlagen

Es ist bekannt, daß mit Hilfe der aufwendigen Kathodenzerstäubung eine große Zahl auch hochschmelzender Verbindungen langsam, das heißt in einem viele Stunden dauernden Vorgang kontinuierlich in beispielsweise Bandbestäubungsanlagen aufkondensiert werden können.

Bisher ist jedoch keine Bandbedampfungsanlage bekannt, in welcher einfache chemische Verbindungen und insbesondere hochschmelzende, anorganische Verbindungen, wie Zinksulfid, Siliciumnitrid, Titandioxid, Siliciummonoxid, Chromoxid und elektrisch leitende oder nicht-leitende Silicatgläser porenfrei
und mit der erforderlichen hohen Geschwindigkeit aufgedampft
werden können. Zwar gibt es viele Arten von Aufdampfquellen,
die entweder das geschmolzene oder noch feste Aufdampfgut
aufzudampfen in der Lage sind, jedoch ist die Aufdampfrate
infolge der geringen und häufig stark entgasenden, Dampf abgebenden Oberfläche des Aufdampfgutes gering, das heißt, die
Aufdampfrate reicht zum kontinuierlichen Bedampfen in großtechnischem Maßstab, bei dem Geschwindigkeiten von bis zu
10 Laufmeter/Sekunde und mehr erforderlich sind, bei weitem
nicht aus. Darüberhinaus werden die Verdampferschiffchen,
die üblicherweise zur Aufnahme des Aufdampfgutes verwendet
werden, durch Kontaktkorrosion rasch zerstört. So war es
bisher nicht möglich, eine einzige Filmrolle von 10 000 Lfm
mit einer zusammenhängenden und porenfreien Schicht einer
Verbindung, beispielsweise Siliciummonoxid, zu bedampfen.

Nicht besser liegen die Verhältnisse bei dem aufwandreichen Elektronenstrahl-Aufdampfverfahren, welches bisher aufgrund der bekannten Cavitations- bzw. Implosionseffekte ebenfalls nur zum diskontinuierlichen Aufdampfen von beispielsweise Siliciummonoxid, eingesetzt werden konnte. Auch mit Hilfe eines Hochleistungslasers als Energiequelle in einer Vorrichtung,bei welcher aus einem kalten Tiegel heraus verdampft wird und somit Tiegelreaktionen vermieden werden, können beispielsweise Siliciumdioxidschichten nur diskontinuierlich hergestellt werden (vgl. DE-A-16 21 306).

Ein weiterer erheblicher Nachteil der bisher bekannten Aufdampfgüter und Aufdampfvorrichtungen für insbesondere hochschmelzende Verbindungen ist die oft unzureichende Qualität der kondensierten Schichten. Diese sind nicht nur porenreich, sondern meistens auch ungenügend dicht und ebenso ungenügend haftfest, da die verdampften Moleküle im besten Falle mit der geringen, nur der Aufdampftemperatur entsprechenden kinetischen Energie auf der Folie oder auf einem anderen Substrat auftreffen. Deshalb war es bisher häufig notwendig, kondensierte Schichten von beispielsweise Siliciummonoxid oder Siliciumdioxid mit Hilfe einer zusätzlich aufkondensierten Schicht von beispielsweise einer in einer Glimmentladung aufpolymerisierten, ebenfalls Silicium enthaltenden Verbindung zu imprägnieren und zu verfestigen. Darüberhinaus kann auch bei sorgfältigem Aufdampfen aus widerstandsbeheizten Verdampferschiffchen das Entstehen von Pünktchen, die durch das Erwärmen des Aufdampfgutes auf der Rückseite als Folge von katapultierten Feinstkörnchen entstehen, nur bei geringsten Aufdampfraten und mit Hilfe von Mehrfachaufdampfkammern vermieden werden. Schließlich gestatten die bekannten Aufdampfgüter und Aufdampfvorrichtungen infolge der durch die geringe Aufdampfrate bedingten geringen Schichtbildungsgeschwindigkeit und der dadurch begünstigten Kristallbildung nur ausnahmsweise das Aufkondensieren von röntgenamorphen Schichten, obwohl letztere beispielsweise als Gas- und Dampfdiffusion hemmende Zusatzschichten für aluminiumbedampfte Verpackungsfolien, Ka-

talysatorgift für autoregenerative Kondensatoren, Farb- und Schutzschichten für Prägefolien und andere dekorative Folien, elektronegative Abdeckung für funkenerosionsgefährdete Metallschicht-Kanten, Kondensatordielektrika und witterungsbeständige Schutzschichten für aluminiumbedampfte Radarschirme von großer Bedeutung sind.

Bei den bekannten Vorrichtungen, die bisher zum Aufdampfen hochschmelzender Verbindungen, wie SiO oder ZnS mittels einer thermischen Strahlungsheizquelle  verwendet wurden, besteht das Aufdampfgut in fester Form, beispielsweise aus Pulvern oder Granulaten, die auch unter Bildung eines selbsttragenden Blockes oder Masse kompaktiert sein können. Die thermische Heizquelle, üblicherweise ein Wolframdraht, ist dabei in einem Hohlraum innerhalb des Aufdampfgutes beispielsweise in Haarnadelform angeordnet, sodaß die verdampften Moleküle durch eine Austrittsöffnung aus dem Hohlraum entweichen können (vgl. US-A-2 762 722).

Bei anderen Ausführungsformen ist das Aufdampfgut in granulierter Form in einem zylinderförmigen Behälter untergebracht. Innerhalb dieses Behälters befindet sich die thermische Heizquelle, beispielsweise in Form eines perforierten Rohres oder eines spiralförmigen Heizdrahtes in vertikaler Anordnung, sodaß die verdampften Moleküle durch den Hohlraum innerhalb des Rohres oder Heizdrahts nach oben entweichen können (vgl. US-A-3 129 315 und US-A-3 153 137). Eine derartige Ausführungsform ist beispielsweise unter der Bezeichnung "Drumheller-Vorrichtung" literaturbekannt.

Bekannt ist auch eine Vorrichtung, bei welcher sich das pulverförmige Aufdampfgut in einem auswechselbaren Behälter befindet, der innerhalb eines Heizzylinders angeordnet ist. Dieser Heizzylinder ist nach außen durch Hitzeschilde abgeschirmt, sodaß die verdampften Moleküle nur nach oben entweichen und dort von einer zweiten Heizquelle in Form eines Gitters zusätzlich beschleunigt oder verdampft werden können (vgl. US-A-3 104 178).

Vorrichtungen, bei welchen das granulierte Aufdampfgut in einem Hohlzylinder mit perforierter Innenwand untergebracht ist und ein Wolframdraht im Inneren des Hohlzylinders angeordnet ist, können durch zusätzliche Stromversorgung auch so geschaltet werden, daß die Verdampfung nicht nur durch thermische Strahlung, sondern zusätzlich durch Elektronenstrahlung vorgenommen werden kann. Dadurch soll ein besonders gleichmäßiges Aufdampfen erreicht und das unerwünschte Herausschleudern unverdampfter Teilchen besser verhindert werden können (vgl. US-A-3 244 857).

Schließlich ist auch eine Vorrichtung zum Aufdampfen hochschmelzender Metalle, wie Chrom bekannt, bei welcher das Aufdampfgut aus einem kompakten Stab besteht, der auf einem festen Träger montiert ist und Stab und Träger innerhalb einer Strahlungsheizquelle, wie einem Hohlzylinder aus Tantalblech angeordnet sind (vgl. US-A-3 313 914).

Bei allen diesen bekannten Vorrichtungen ist jedoch das Aufdampfgut in fester Form stationär angeordnet, unabhängig davon, ob es als Pulver oder Granulat in einem Behälter untergebracht oder kompaktiert als selbsttragender Festkörper vorliegt. Dieses Aufdampfgut ist mit einer Strahlungsheizquelle kontaktlos verbunden, die ebenfalls stationär angeordnet ist. Derartige Vorrichtungen mit stationärer Anordnung von Aufdampfgut und Strahlungsheizquelle können in üblichen Vakuumaufdampfapparaturen zum diskontinuierlichen Aufdampfen von insbesondere hochschmelzenden Verbindungen in der jeweils für eine Charge erforderlichen Menge eingesetzt werden, da hierdurch ein "Spuckerfreies" Aufdampfen mit hoher kinetischer Energie der verdampften Moleküle und hoher Aufdampfgeschwindigkeit ermöglicht wird. Für kontinuierlich betriebene Vakuumbedampfungsanlagen, in welchen ein großer Vorrat an Aufdampfgut benötigt wird, sind derartige Vorrichtungen indessen nicht geeignet, weil die Strahlungsheizquelle mit zunehmendem Verbrauch des Aufdampfguts immer stärker erhitzt werden muß um bei unverändertem Dampfdruck ein gleichmäßiges Aufdampfen zu ermöglichen. Das führt zu lokaler Überhitzung der Heizquelle und damit häufig zu einer vorzeitigen Zerstörung derselben.

Nicht weniger nachteilig ist der Umstand, daß einige Verbindungen, wie beispielsweise Siliciumnitrid, im Vakuum beim Erhitzen in Stickstoff und elementares Silicium zerfallen und das Aufdampfen des letzteren praktisch nur nach dem Absaugen des Stickstoffes durch die Vakuumpumpen der kontinuierlichen Vakuumbedampfungsanlage beginnt. Wird hingegen Siliciumnitrid laufend der thermischen Strahlungsheizquelle zugeführt, so dampft nicht nur Silicium auf, sondern es entweicht auch gleichzeitig Stickstoff aus jenen Teilen des Aufdampfgutes, die nicht unmittelbar von der Strahlungsheizquelle bestrahlt werden, so daß das verdampfende Silicium wieder Stickstoff aufnehmen (gettern) kann.

Auch bilden viele Pulvermischungen, die Übergangsmetalle enthalten, beim Erhitzen im Vakuum nicht nur eine einzige, sondern mehrere Verbindungen mit unterschiedlichen Dampfdrücken, so daß die Verbindung mit dem niedrigsten Dampfdruck erst am Ende eines klassischen Aufdampfverfahrens verdampft und als Ergebnis eine nicht homogene kondensierte Schicht ergibt. So wird beispielsweise aus einer Mischung von 3 Gewichtsteilen $Cr_2O_3$ mit 1 Gewichtsteil Si, welche im Vakuum mit Hilfe einer auf etwa 2000°C erwärmten Strahlungsheizquelle erhitzt wird, zuerst eine dielektrische Schicht aufgedampft, doch findet nach der erforderlichen weiteren Erhöhung der Temperatur ein progressiver Übergang des anschließend entstandenen Kondensats in eine elektrisch leitende Schicht statt. Wird hingegen dieselbe Schicht kontinuierlich aufgedampft, mit Hilfe einer auf etwa 2000°C erwärmten Strahlungsheizquelle der das Aufdampfgut mit gleichbleibender Geschwindigkeit zugeführt wird, so erhält man ein homogenes, elektrisch leitendes Glas als auf die Folie oder dergleichen aufkondensierte Schicht.

Es stellt sich somit die Aufgabe, eine Vorrichtung für das Aufdampfen von hochschmelzenden anorganischen Verbindungen mittels einer Photonen erzeugenden thermischen Strahlungsheizquelle, in kontinuierlich betriebenen Vakuumbedampfungsanlagen zur Verfügung zu stellen, die ein gleichmäßiges "Spuckerfreies" Aufdampfen der hochschmelzenden Verbindungen auf beliebige Substrate aus einem großen Aufdampfgutvorrat ermöglicht, ohne daß die thermische Heizquelle durch lokale Überhitzung vorzeitig zerstört wird.

Diese Vorrichtung besteht aus dem Aufdampfgut in fester Form, das aus mindestens einer pulverförmigen anorganischen Verbindung mit einem Schmelzpunkt von $>$ 1000°C oder aus Gemischen von mindestens einer pulverförmigen anorganischen Verbindung mit einem Schmelzpunkt von $>$ 1000°C und mindestens einem pulverförmigen Element mit einem Schmelzpunkt von $>$ 1000°C durch Verdichten und Formgebung hergestellt worden ist und aus der thermischen Strahlungsheizquelle, wobei Aufdampfgut und thermische Strahlungsheizquelle kontaktlos verbunden sind.

Die Aufgabe wird erfindungsgemäß dadurch gelöst, daß das Aufdampfgut als mindestens ein, vorzugsweise poröser Festkörper ausgebildet ist und Festkörper und/oder thermische Strahlungsheizquelle beweglich angeordnet sind.

Die erfindungsgemäße Vorrichtung kann grundsätzlich so aufgebaut sein, daß der Festkörper oder die thermische Strahlungsheizquelle oder beide mechanisch bewegt werden können. Aus Gründen des einfacheren Aufbaus der Vorrichtung sind jedoch Ausführungsformen bevorzugt, in welchen nur der Festkörper beweglich angeordnet ist und die thermische Strahlungsheizquelle unbeweglich oder stationär angeordnet ist.

Die in der erfindungsgemäßen Vorrichtung als Aufdampfgut verwendeten, vorzugsweise porösen Festkörper können von beliebiger Form und Größe sein. Vorteilhaft sind sie als Hohlkörper ausgebildet. Als Anhaltspunkt für die Größe dient das Gewicht, das im allgemeinen im Bereich von etwa 10 bis 100 g liegen kann. Die Größe der vorhandenen Poren muß mindestens im Bereich der Lichtwellenlänge liegen für das Eindringen der Photonen aus der Strahlungsheizquelle, und die Dampf erzeugende Oberfläche muß ausreichend groß sein, um das gleichmäßige Aufdampfen mit hoher Aufdampfrate zu gewährleisten. Die porösen Festkörper müssen außerdem genügend standfest sein, damit sie auch bei kontinuierlichem Nachschub leicht gehandhabt werden können.

Die porösen Festkörper können aus den pulverförmigen Ausgangsmaterialien nach beliebigen bekannten Formgebungsverfahren hergestellt werden. Für die Formgebung können Pulver oder Pulvergemische zusammen mit einem temporären Bindemittel vermischt oder in einem Lösungsmittel dispergiert werden. Die Mitverwendung des temporären Bindemittels ist jedoch nicht unbedingt erforderlich. Die Formgebung kann durch übliche bekannte Maßnahmen, beispielsweise durch Gesenkpressen, isostatisches Pressen, Spritzgießen, Strangpressen oder Schlickergießen bei Raumtemperatur oder erhöhter Temperatur vorgenommen werden. Nach der Formgebung werden die porösen Festkörper vorteilhaft einer thermischen Behandlung durch Erhitzen auf mindestens 500°C unterzogen. Durch die thermische Behandlung kann eine zusätzliche Verfestigung der porösen Festkörper und eine praktisch vollständige Entgasung derselben erreicht werden. Durch diese zusätzliche Verfestigung des Aufdampfgutes, worunter ein festeres Zusammenbacken oder sogar Sintern zu verstehen ist, wird das unerwünschte "Spucken" oder Herumspringen einzelner Feststoffteilchen während des Aufdampfvorgangs vermieden, das bei einem aus losem Pulver oder Granulat bestehendem Aufdampfgut häufig zu beobachten ist. Die Entgasung des Aufdampfgutes ist insbesondere bei kontinuierlichem Nachfüttern aus einem Magazin vorteilhaft. Hierdurch wird verhindert, daß das·Aufdampfgut während des Aufdampfvorgangs entgast, was zu einer
vorzeitigen Zerstörung der Photonen-Quelle durch Umwandlung
in flüchtige Sauerstoffverbindungen führen kann.

Als thermische Strahlungsheizquelle zum Erzeugen der Photonen
kann eine bekannte Heizquelle verwendet werden, die beispielsweise aus einem hochschmelzenden Draht oder Stab besteht und
die vorzugsweise induktionsarm ausgebildet ist. Beispiele
hierfür sind in Mäanderform oder bifilar gewickelte Strahlungsheizkörper aus Wolfram.

Die erfindungsgemäße Vorrichtung mit vorzugsweise beweglicher
Anordnung des aus porösen Festkörpern bestehenden Aufdampfgutes ermöglicht den verhältnismäßig einfachen Aufbau von Aufdampfvorrichtungen, die zum kontinuierlichen Verdampfen von
mehreren 1000 Gramm hochschmelzender Verbindungen geeignet
sind. Das Aufdampfgut kann beispielsweise als poröser Hohlkörper ausgebildet sein, der in einer Haltevorrichtung angeordnet ist, die als Hohlkammer mit Öffnungen ausgebildet ist
und die gleichzeitig als Strahlungsschutz dient. Die Strahlungsheizquelle ist innerhalb des Hohlkörpers angeordnet und
mit diesem kontaktlos verbunden.

Werden an der Hohlkammer Magazine zum Nachfüttern des Aufdampfgutes angebracht, so kann dieses in beliebiger Richtung mechanisch oder allein durch die Schwerkraft bewegt
werden.
Wird das Aufdampfgut nicht allein, sondern auf Trägern, die
beispielsweise aus SiC-Plättchen bestehen, nachgefüttert, so
können die Träger anschließend aus der Hohlkammer in entleertem oder teil-entleertem Zustand ausgestoßen werden.
Gemäß einer Ausführungsform der Erfindung ist das Aufdampfgut in Form von Hohlzylindern, wie Hülsen oder Ringen ausgebildet, die kontaktlos mit einer koaxial eintauchenden
Heizspirale verbunden sind. Die Hohlzylinder sind in einer
Hülse aus Stahl oder anderem hochschmelzendem Material untergebracht, die als Haltevorrichtung dient. Die Hülse ist
beweglich angeordnet, sodaß sie während des Aufdampfvorganges zusammen mit den Hohlzylindern bewegt werden kann. Die Hohlzylinder können jedoch auch in
einer festmontierten Trägerhülse beweglich angeordnet sein,
sodaß sie während des Aufdampfvorganges allein bewegt werden können. Hierbei ist die Wärmebelastung der Trägerhülse
verhältnismäßig gering, da das Aufdampfgut selbst mindestens
teilweise als Wärmeisolator wirkt.

Durch die bewegliche Anordnung der Hohlzylinder mit oder ohne Haltevorrichtung bei unbeweglich angeordneter Heizspirale
ist sichergestellt, daß während des Aufdampfvorganges unverbrauchtes Aufdampfgut kontinuierlich nachgeliefert wird und
dadurch eine lokale Überhitzung der Heizspirale vermieden
wird.

Gemäß einer weiteren Ausführungsform der Erfindung ist das
Aufdampfgut als Vollkörper ausgebildet, der kontaktlos von
außen mit einer Strahlungsheizquelle verbunden ist. Dieser
Vollkörper ist beweglich auf einem Träger angeordnet und wird
in situ, das heißt im Laufe des Aufdampfvorganges von der
Strahlungsheizquelle selbst durch Verdampfen progressiv ausgehöhlt oder aufgebohrt. Zur Erleichterung des allein durch
Strahlungseinwirkung eintretenden Vorgangs kann die Strahlungsheizquelle mit vorzugsweise erhöhter Strahlenabgabe an
der Spitze ausgebildet sein, die beispielsweise durch dichtere Wicklung einer als Heizquelle eingesetzten Wolframspirale oder Verjüngen der letzteren beispielsweise durch elektrolytisches Polieren erreicht werden kann. Zusätzlich kann
der Vollkörper an seiner Oberfläche mit Einkerbungen versehen
sein, der kontaktlos mit einer in diese Einkerbungen eintauchenden Heizspirale verbunden ist.
Auch in diesem Falle ist sichergestellt, daß durch Nachschieben des Vollkörpers in Richtung der unbeweglich angeordneten
Heizquelle unverbrauchtes Aufdampfgut kontinuierlich nachgeliefert wird.

Ein weiterer wichtiger Beitrag zur Erzielung der gewünschten
großen verdampfenden Oberfläche des Aufdampfgutes ergibt sich aus der bevorzugten Porosität des Festkörpers. Dadurch entsteht eine die scheinbare Oberfläche erheblich übertreffende effektive Oberfläche, welche viele kleine, zum Einfangen der Photonen besonders gut geeignete hohlraumförmige Vertiefungen aufweist. Dadurch werden aber die Anforderungen an die Strahlungsheizkörper besonders groß und damit diese die erforderliche hohe Strahlungsdichte auch leisten können, soll die Oberfläche des Strahlungsheizkörpers nicht oder nicht erheblich kleiner sein als die scheinbare Oberfläche des bestrahlten Teiles des Aufdampfgutes, insbesondere wenn Aufdampfgüter mit geringer Flüchtigkeit, wie die Oxide von Cerium oder Titan eingesetzt werden.

Die hohe Temperatur der photonenabstrahlenden Heizquelle begünstigt auch das in situ, das heißt erst im Laufe des Aufdampfprozesses erfolgte Erzeugen von hochschmelzenden, zum Teil bisher unbekannten chemischen Verbindungen aus verschiedenen verfestigten Pulvermischungen. So kann beispielsweise aus den bekannten Mischungen von Silicium mit Siliciumdioxid (hochdisperse Kieselsäure) das gewünschte Reaktionsprodukt Siliciummonoxid infolge der entstehenden Reaktionswärme bereits bei Temperaturen von weniger als 1000°C des Aufdampfgutes intensiv aufgedampft werden. Mischungen von Pulvern hochschmelzender, flüchtige Sauerstoffverbindungen erzeugender Elemente, wie B, Cr, Fe, Ge, Mo, Nb und Si mit beim Erhitzen in Vakuum Sauerstoff abgebenden Verbindungen, wie verschiedene Sauerstoffverbindungen von Co, Cr, Fe und Si eignen sich zur Herstellung einer großen Anzahl von verschiedenen, in der kontinuierlichen Aufdampftechnik und insbesondere in der Bandbedampfungstechnik bisher unbekannten Beschichtungen. Aus Mischungen von Si und $Cr_2O_3$ können somit

homogene, elektrisch leitende Gläser aufgedampft werden, obwohl aus solchen Gläsern bestehende dünne Schichten bisher nur nach Schmelzen der Mischungen in inertem Gas und nachfolgendes Aufstäuben der erstarrten Schmelze mit Hilfe der aufwendigen Kathodenzerstäubung erzielt werden konnten.

Ein reaktives Aufdampfen, wie die Umwandlung von Siliciummonoxid in Siliciumdioxid kann beispielsweise wie folgt durchgeführt werden: Aus einem hohlraumförmigen, mit in diesem kontaktlos eingetauchter Heizquelle erhitzten Aufdampfgut wird im Hochvakuum Siliciummonoxid verdampft. Sobald der aus dem Hohlraum herausströmende SiO-Dampf die erwünschte Intensität erreicht, wird in die Vakuumanlage Sauerstoff vom erforderlichen Partialdruck, beispielsweise ungefähr 4,0 Pa eingelassen. Da der Partialdruck des Sauerstoffs viel niedriger ist, als der Dampfdruck des aus dem hohlraumförmigen Aufdampfgut strömenden SiO-Dampfes, kann der Sauerstoff, die aus beispielsweise Wolfram bestehende Heizquelle nicht angreifen. Es wird dementsprechend das kontinuierliche reaktive Aufdampfen ermöglicht, um so mehr, als die Heizquelle vom SiO-Dampf nicht merkbar korrodiert wird.

Bei bestimmten Anwendungen, beispielsweise bei gleichzeitigem Aufdampfen mehrerer Schichten in einer Bandbedampfungsanlage, kann es vorteilhaft sein, einzelne Heizquellen in horizontaler oder schräger Lage anzuordnen. Damit in solchen Fällen das Aufdampfgut sicher gehalten oder geführt wird und nicht einzelne seiner Teile auf die Heizquelle fallen, ist die Möglichkeit vorgesehen, das Aufdampfgut auf einen Träger beweglich anzuordnen oder beide so zu verbinden, daß Aufdampfgut und Träger gemeinsam bewegt werden können.

Die für die serienmäßige Herstellung günstige Hülsen- und Zylinderform des vorzugsweise porösen Festkörpers gestattet auch ihre vorteilhafte Anwendung als Aufdampfgut in zusätzlich mit Elektronenstrahlkanonen ausgerüsteten Aufdampfanlagen. So können beispielsweise der oder die Zylinder auf
eine drehbare, zwecks Entgasen vorzugsweise mit einer Heizvorrichtung versehene Achse oder Walze montiert werden. Durch
langsames Rotieren der Vorrichtung wird das Aufdampfgut gleichmäßig durch Photonen- und Elektronenbeschuß abgedampft. Nicht
nur ein Zylinder von außen, sondern auch ein Hohlkörper von
innen kann zusätzlich mit Elektronen beschossen und verdampft
werden, in dem beispielsweise zwischen einer aus einer Wolframspirale bestehenden Kathode und gleichzeitiger Photonen-
quelle und einer Anode und gleichzeitigem Strahlungsschutzblech eine entsprechende Spannung gelegt und das hohlraumförmige Aufdampfgut durch die kombinierte Wirkung von Elektronen und Photonen verdampft wird. Erfahrungsgemäß werden
bogenförmige Entladungen bereits durch das intensiv vor sich
gehende Verdampfen verhindert, sonst können solche mit bekannten Mitteln, wie beispielsweise Magnetfeldern verhindert werden.


Die erfindungsgemäßen Vorrichtungen mit beweglicher Anordnung
des aus porösen Festkörpern bestehenden Aufdampfgutes und unbeweglicher Anordnung der thermischen Strahlungsheizquelle
sind insbesondere für den Einsatz in kontinuierlich betriebenen Bandbedampfungsanlagen geeignet, da hiermit auch breite,
beispielsweise aus Kunststoff oder Papierfolien bestehende
Substrate auf ihrer ganzen Breite gleichmäßig bedampft werden
können.

Darüberhinaus kann die Gleichmäßigkeit durch ein doppeltes
Aufdampfverfahren weiter gesteigert werden, indem zuerst
ein aus einem hochschmelzenden Metall oder einer solchen Verbindung bestehendes Substrat bedampft und die kondensierte
Schicht in einem getrennten oder noch in derselben Vakuumanlage erfolgenden Aufdampfverfahren durch konventionelle
Methoden (Elektronenbeschuß, Photonenbestrahlung oder Widerstandserwärmung) auf das zweite, also endgültige, beispielsweise folienförmige Substrat übertragen wird. Wird beispielsweise ein Stahl- oder Molybdänband, welches auf einer langsam rotierenden Walze befestigt ist und mit einer nicht ganz
gleichmäßigen SiO-Schicht bedampft wird, während des Rotierens
erneut erhitzt und zwar zu einem Zeitpunkt, da es sich parallel und in der Nähe der Leitwalze der Kunststoff-Folie befindet, so kann ein Teil der aufkondensierten SiO-Schicht vollkommen gleichmäßig auf die Kunststoff-Folie übertragen werden, denn die auf dem Metallband entstandenen Ungleichmäßigkeiten der SiO-Schichtdicke sind sehr klein im Vergleich zum
Abstand Metallband-Leitwalze. Eine Voraussetzung der erwünschten, bisher nur mit Hilfe der aufwendigen und langsamen Kathodenzerstäubung erzielbaren gleichmäßigen Folienbeschichtung
ist allerdings, daß der erste Träger, das heißt das Metallband
im beschriebenen Fall, sehr gleichmäßig erwärmt wird und seine
Abmessungen so gewählt sind, daß es - um ein Absinken der
Schichtdicke am Rande der Folie zu vermeiden - diese etwas
überragt. Bei diesem neuen zweistufigen "Destillierverfahren"
tritt also anstelle der chemischen eine physikalische Veredellung ein, die sich vorzüglich zur Herstellung von im Bandbedampfungsverfahren bisher nicht bekannten Produkten eignet.
Das Verfahren kann mit einem konventionellen Metallisieren
kombiniert werden und es können auch gleichzeitig mehrere veredelte Schichten auf dasselbe endgültige Substrat übertragen
werden. Dementsprechend können neue, auf Kunststoff-Folien
aufkondensierte Interferenzfilter, Dekorationsfolien, Prägefolien, in welchen die gesamte Beschichtung in einem einzigen
Arbeitsgang bis und inklusive der Metallschicht aufgedampft
und somit die mit verschiedenen Nachteilen behaftete, farbige
oder ungefärbte organische Lackschicht durch eine bedeutend
bessere und billigere, keine umweltfeindliche Lösungsmittel
benötigende, anorganische Schicht ersetzt werden kann, erzeugt
werden. Es ist somit möglich, einen altbekannten Effekt mit neuen und entschieden einfacheren Mitteln zu erzeugen.

Eine unerwünschte chemische Reaktion der übertragenen Schicht
mit dem Überträger tritt praktisch nicht ein, da die aus den
Pulvermischungen gebildeten Reaktionsprodukte im allgemeinen
weniger korrosiv sind, als die Bestandteile der Pulvermischungen selbst; außerdem bilden die auf dem Überträger kondensierten Schichten einen hervorragenden Kontakt mit diesem und können dementsprechend leicht erwärmt werden.

Der Gegenstand der Erfindung wird anhand der Figuren 1 bis 7 näher erläutert.

Fig. 1 zeigt eine erste Ausführungsform der Vorrichtung im Längsschnitt, horizontal arbeitend, bei Arbeitsbeginn;

Fig. 2 zeigt die Vorrichtung nach Fig. 1 in einer Zwischenarbeitsstellung;

Fig. 3 zeigt eine andere Ausführungsform im Längsschnitt, horizontal arbeitend;

Fig. 4 zeigt eine Ausführungsform im Längsschnitt, vertikal arbeitend;

Fig. 5 zeigt eine weitere Ausführungsform im Längsschnitt, vertikal arbeitend dargestellt;

Fig. 6 zeigt in Perspektive und schematisch die Strahlungsheizquelle von Fig. 5;

Fig. 7 zeigt die Anordnung von erfindungsgemäßen Vorrichtungen in einer kontinuierlich betriebenen Bedampfungsanlage für ein doppeltes Aufdampfverfahren in schematischer Darstellung.

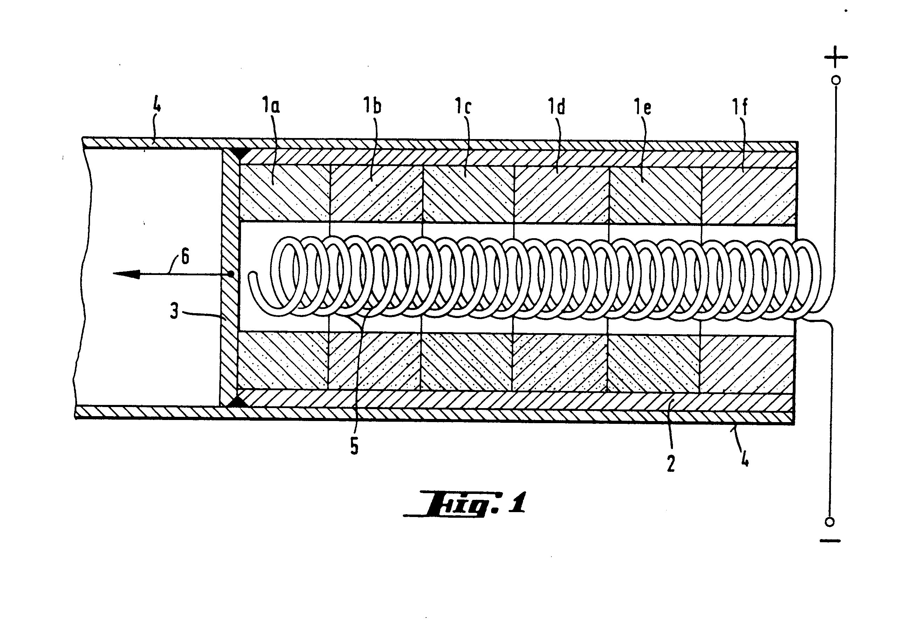

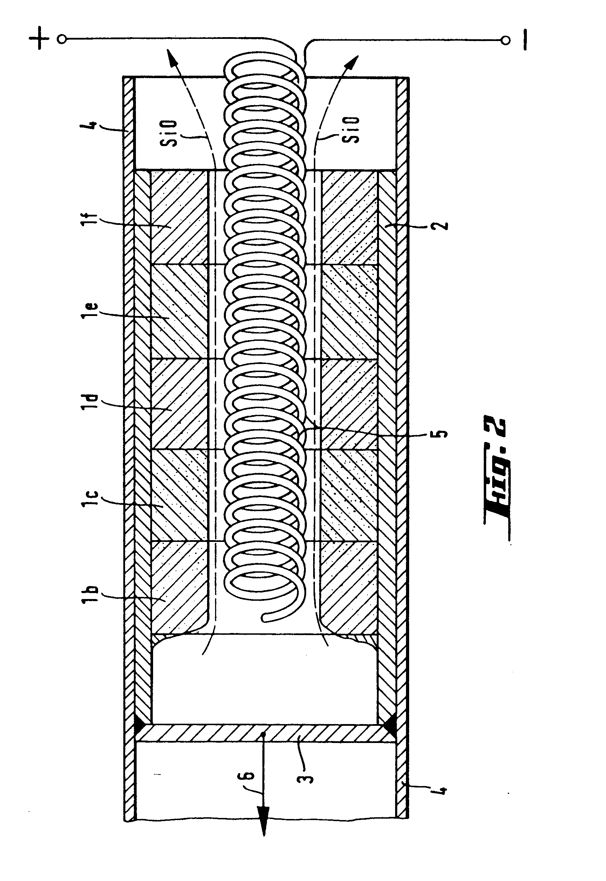

Zu Figur 1 und 2:

In der waagrechten Stahlhülse 2 von 200 mm Länge, einem Außendurchmesser von 50 mm und einem Innendurchmesser von 46 mm, die an einem Ende durch den angeschweißten Stahlboden 3 verschlossen ist, sind die porösen Aufdampfgutringe 1a bis 1f, die durch Verpressen von Pulvergemischen aus einem Gew.-Tl. Si + 2 Gew.-Tl. $SiO_2$ hergestellt wurden, nebeneinander angeordnet (Fig. 1). Zur Entgasung des Aufdampfgutes wurde die Stahlhülse samt Inhalt einige Minuten unter Luftzutritt auf 500°C erhitzt, bevor sie in einer zweiten Stahlhülse, die als Trägerhülse 4 dient, beweglich angeordnet wird, so, daß sie in Pfeilrichtung 6 mechanisch bewegt werden kann. Als Strahlungsheizquelle 5 dient ein Wolframdraht von 3 mm Durchmesser und 2000 mm Länge, der bifilar in enger Wicklung zu einer Spirale mit einem Innendurchmesser von 20 mm geformt ist. Diese Spirale 5 wird durch das offene Ende der der ersten Stahlhülse 2 so eingeführt, daß sie die Aufdampfgutringe 1a bis 1f nicht berührt und etwa 10 mm vor dem Boden 3
endet und in dieser Stellung fixiert ist. Bei Einsatz dieser
Vorrichtung in einer kontinuierlichen Bedampfungsanlage, die
unter einem Druck von 0,0133 Pa und Erhitzen der Stahlungsheizquelle 5 durch Widerstandserwärmung auf etwa 1800°C betrieben wird, beginnt der am Boden 3 befindliche Aufdampfgutring 1a, der durch das Ende der Heizspirale 5 am stärksten
erhitzt wird, zu verdampfen. Nach Verbrauch dieses Ringes 1a
unter Bildung von SiO-Dampf, der durch das offene Ende der
Stahlhülse 2 entweicht, wird die Stahlhülse 2 in Pfeilrichtung 6 bewegt (Fig. 2), so daß nunmehr der Aufdampfgutring
1b zu verdampfen beginnt. Durch weiteres Hineinziehen der
Stahlhülse 2 in Richtung des Pfeiles 6 mit den darin angeordneten Aufdampfgutringen in die Trägerhülse 4 können somit auch
die Ringe 1c bis 1f nacheinander verdampfen. Durch diese kontinuierliche Nachlieferung von unverbrauchtem Aufdampfgut
bleibt die Leistung der Strahlungsheizquelle 5 und damit deren
Energiebedarf praktisch unverändert. Auf diese Weise wird das
Überhitzen und damit das vorzeitige Zerstören der Stahlungsheizquelle 5 wirksam verhindert. Es wurde festgestellt, daß
mit dieser Ausführungsform von beweglich angeordnetem Aufdampfgut und festmontierter Strahlungsheizquelle Standzeiten
für die Strahlungsheizquelle von mehr als 100 Stunden erreicht
werden konnten.

Zusätzlich kann die Stahlhülse 2, die mit den Aufdampfgutringen 1a bis 1f beschickt ist, während des Aufdampfvorganges gedreht werden, wodurch ein besonders gleichmäßiges Erhitzen der Innenoberfläche der Aufdampfgutringe erreicht
wird.

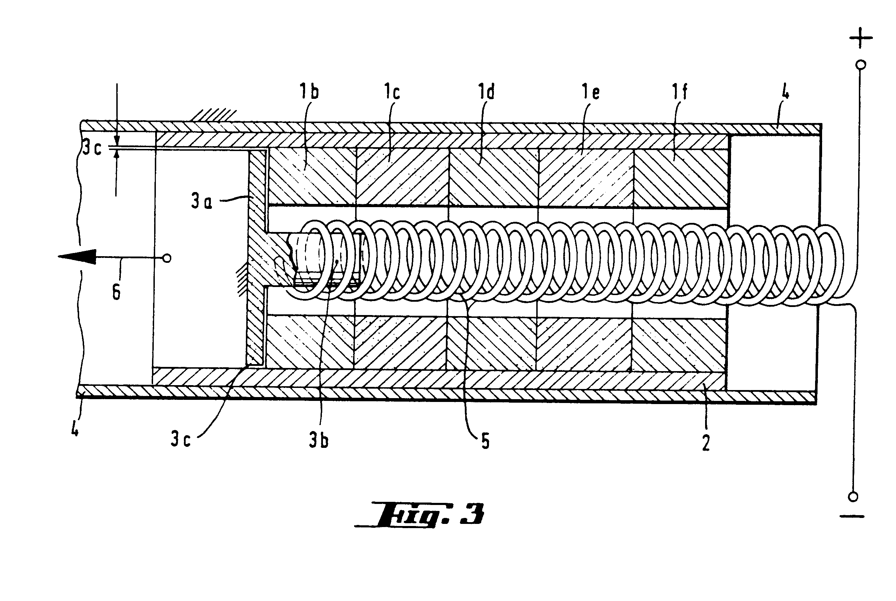

In Fig. 3 ist eine Ausführung gezeigt, bei welcher die Strahlungsheizquelle 5 endseitig, das heißt bodenseitig, ebenfalls
abgestützt ist, und zwar durch einen Boden 3a aus Sinterkeramik mit Stützstift 3b. Um diesen ortsfesten Boden 3a herum
kann sich die Stahlhülse 2 gleitend bewegen dank eines kleinen Spiels 3c.

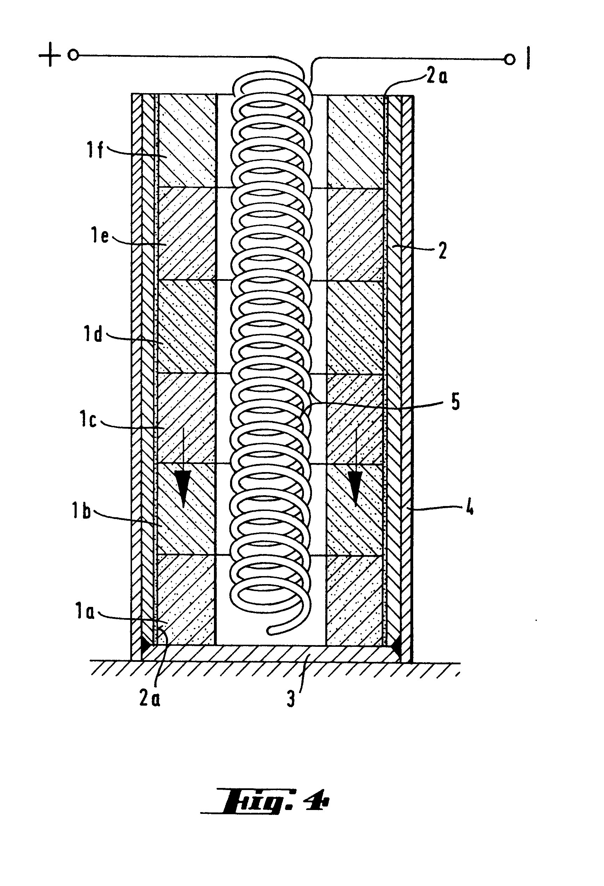

Bei vertikaler Anordnung gem. Fig. 4 der Aufdampfvorrichtung
in der Bedampfungsanlage können auch die Stahlhülse 2 und
der Boden 3 unbeweglich montiert sein, sodaß nur die Aufdampfgutringe 1a bis 1f nach Verbrauch allein durch die Schwerkraft
bewegt werden. Hierbei ist es vorteilhaft, zwischen den Aufdampfgutringen 1a bis 1f und der Stahlhülse 2 eine Gleitschicht
2a anzubringen.

Die Anordnungen nach Fig. 1 bis 3 können auch vertikal betrieben werden.

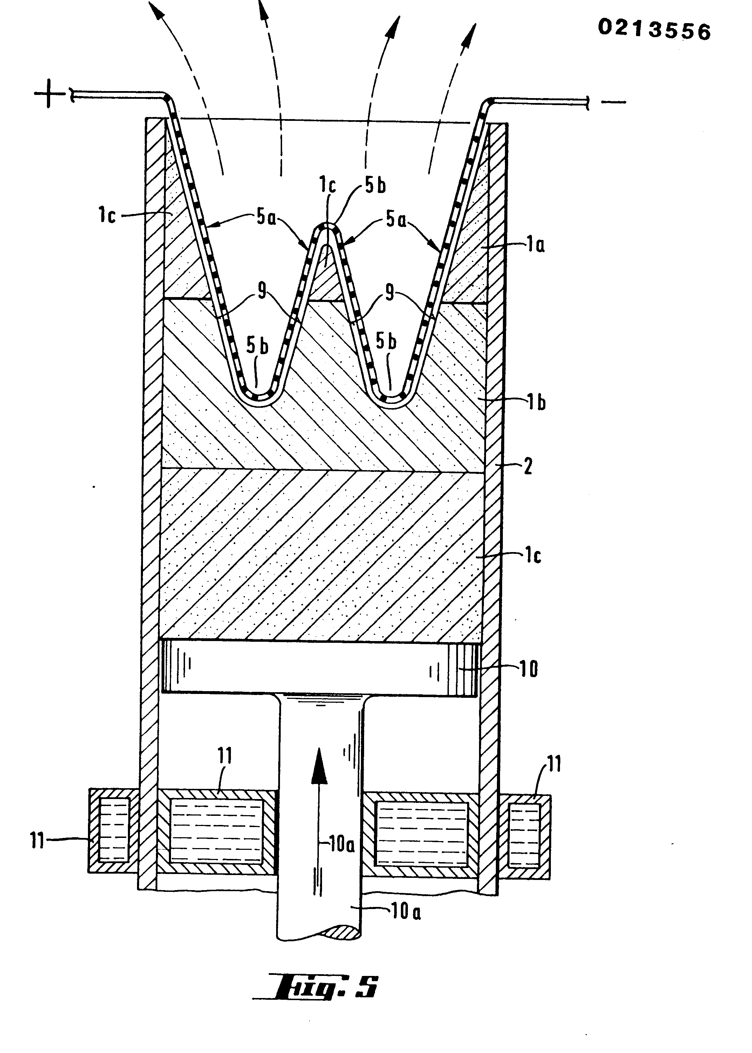

Die Figur 5 zeigt eine Ausführung welche waagrecht und senkrecht arbeitend verwendbar ist.

In dem aus hochschmelzendem Material hergestelltem Vierkantrohr 2 ist scheibenförmiges oder massives Aufdampfgut 1a....
usw. eingebracht.

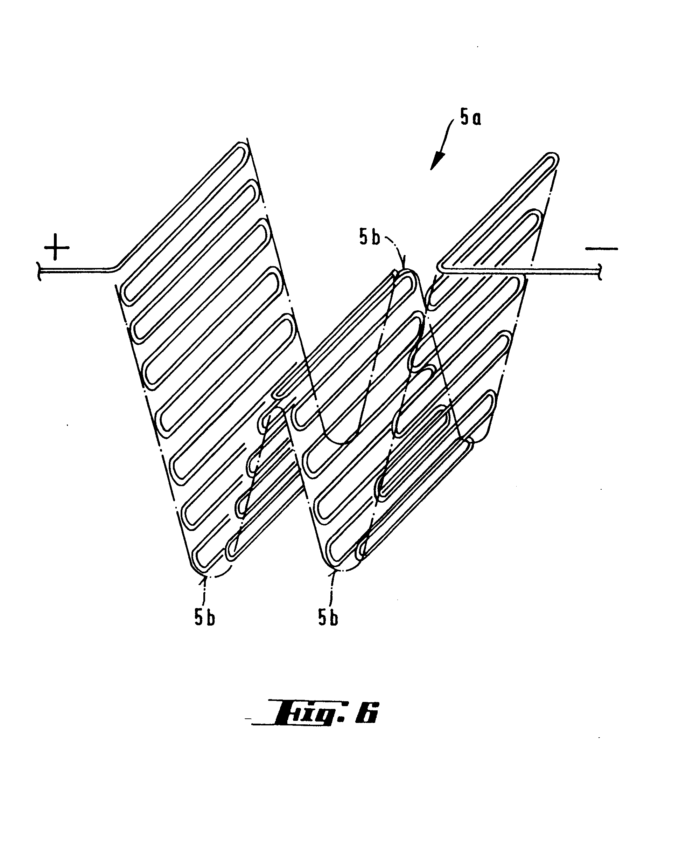

Am oberen bzw. vorderen Ende taucht in das Rohr 2 eine Strahlungsheizquelle 5a ein, welche doppelmäanderförmig geformt ist
wie das Fig. 6 in Perspektive zeigt.

Ein Stempel 10 sorgt für Nachschub in Richtung des Pfeils 10a.

Eine Kühleinrichtung 11 kühlt vor dem Lufteinlassen.

Bei Einsatz dieser Vorrichtung in einer kontinuierlichen
Bedampfungsanlage, die unter einem Druck von 0,0133 Pa
und Erhitzen der Stahlungsheizquelle 5a durch Widerstandserwärmung auf etwa 1800°C betrieben wird, beginnt das Aufdampfgut in den Einkerbungen 9 des Festkörpers 1a zu verdampfen unter Bildung von Dampf, der nach oben entweicht.

0213556

Durch Nachschieben der Festkörper 1a ..... usw. in Pfeilrichtung 10a
das heißt in Richtung der keilförmigen Spitzen 5b der Strahlungsheizquelle 5a wird das Aufdampfgut durch die Strahlungswärme ebenfalls keilförmig weiter abgetragen und verdampft.

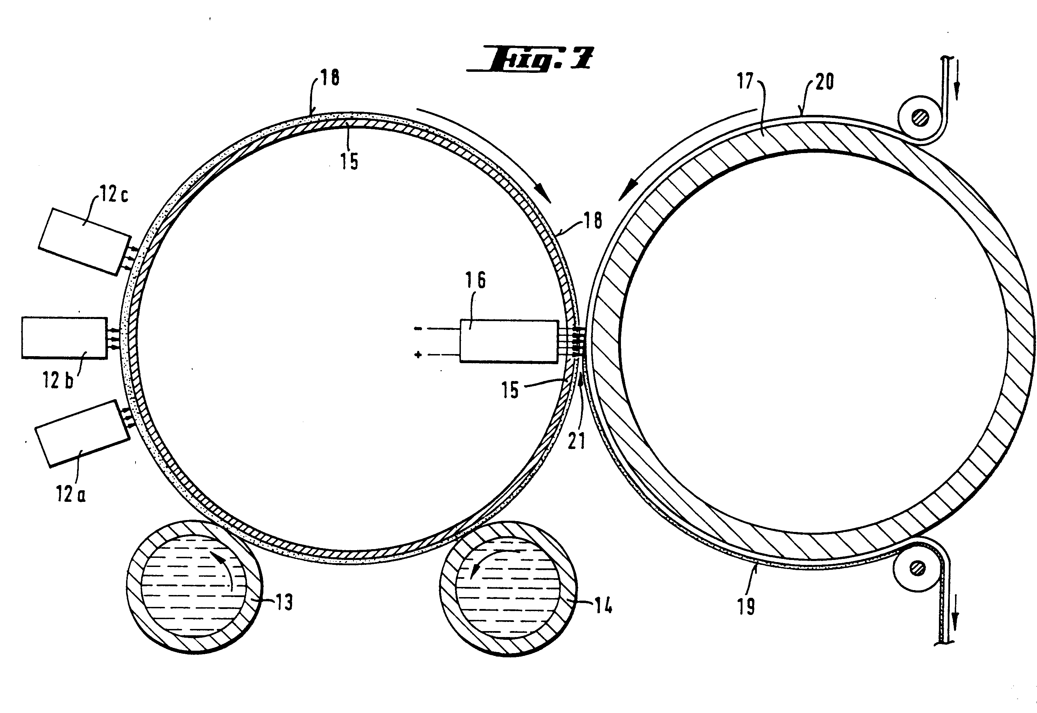

Zu Figur 7:

Der durch die wassergekühlten Trägerwalzen 13 und 14 im Uhrzeigersinn rotierende hülsenförmige Überträger 15 wird durch
die Aufdampfvorrichtungen 12a, 12b und 12c, die erfindungsgemäß aus beweglich angeordnetem Aufdampfgut und unbeweglich
angeordneter Heizquelle gemäß den vorstehend gezeigten Ausführungsformen bestehen, bedampft. Durch die Elektronenkanone 16 wird ein streng definierter Teil des thermisch gut
leitenden Überträgers 15 erhitzt. Dadurch wird ein Teil der
auf dem Träger 15 aufkondensierten Primär-Schicht 18 auf die
Folien 20 tragende Leitwalze 17 in Strahlungsrichtung 21
übertragen. Bei ausreichender Dicke der auf dem Träger 15
kondensierten Primär-Schicht 18 wird die Dicke und die Gleichmäßigkeit der auf die Folien 20 tragende Leitwalze 17 übertragene Sekundär-Schicht 19 nur durch die Emission der Elektronenkanone 16 und den relativen Geschwindigkeiten des
Überträgers 15 und der Leitwalze 17 bestimmt.

Patentansprüche:

1. Vorrichtung für das Aufdampfen von hochschmelzenden anorganischen Verbindungen mittels einer Photonen erzeugenden thermischen Strahlungsheizquelle in kontinuierlich betriebenen Vakuumbedampfungsanlagen bestehend aus dem Aufdampfgut in fester Form, das aus mindestens einer pulverförmigen anorganischen Verbindung mit einem Schmelzpunkt von $>$ 1000°C oder aus Gemischen von mindestens einer pulverförmigen anorganischen Verbindung mit einem Schmelzpunkt von $>$ 1000°C und mindestens einem pulverförmigen Element mit einem Schmelzpunkt von $>$ 1000°C durch Verdichten unter Formgebung hergestellt worden ist, und aus der thermischen Strahlungsheizquelle, wobei Aufdampfgut und thermische Strahlungsheizquelle kontaktlos verbunden sind,
d a d u r c h   g e k e n n z e i c h n e t,
daß das Aufdampfgut als mindestens ein Festkörper ausgebildet ist und Festkörper und/oder thermische Strahlungsheizquelle beweglich angeordnet sind.

2. Vorrichtung nach Anspruch 1,
d a d u r c h   g e k e n n z e i c h n e t,
daß das Aufdampfgut als mindestens ein poröser Festkörper ausgebildet ist und poröser Festkörper und/oder thermische Strahlungsheizquelle beweglich angeordnet sind.

3. Vorrichtung nach Anspruch 1,
d a d u r c h   g e k e n n z e i c h n e t,
daß das Aufdampfgut als mindestens ein Festkörper ausgebildet ist, der Festkörper beweglich und die thermische Strahlungsheizquelle unbeweglich angeordnet ist.

4.   Vorrichtung nach Anspruch 1,
     d a d u r c h   g e k e n n z e i c h n e t ,
     daß das Aufdampfgut als mindestens ein Hohlkörper
     ausgebildet ist, der Hohlkörper beweglich und die thermische
     Strahlungsheizquelle innerhalb des Hohlkörpers angeordnet
     ist.

5.   Vorrichtung nach Anspruch 4,
     d a d u r c h   g e k e n n z e i c h n e t ,

     daß das Aufdampfgut als mindestens ein poröser Hohlzylinder ausgebildet ist, der kontaktlos mit einer koaxial eintauchenden Heizspirale verbunden ist.

6.   Vorrichtung nach Anspruch 1,
     d a d u r c h   g e k e n n z e i c h n e t ,
     daß das Aufdampfgut als mindestens ein Vollkörper
     augebildet ist, der Vollkörper beweglich und die thermische
     Strahlungsheizquelle außerhalb des Vollkörpers unbeweglich
     angeordnet ist.

7.   Vorrichtung nach Anspruch 6,
     d a d u r c h   g e k e n n z e i c h n e t ,
     daß das Aufdampfgut als ein poröser Vollkörper mit Einkerbungen an der Oberfläche ausgebildet ist, der kontaktlos
     mit einer in diese Einkerbungen eintauchenden Heizspirale
     verbunden ist.

8.   Vorrichtung nach Anspruch 1,
     d a d u r c h   g e k e n n z e i c h n e t ,
     daß das Aufdampfgut auf einem Träger beweglich angeordnet
     oder mit einem beweglich angeordneten Träger verbunden ist
     derart, daß der unbeweglich angeordneten Strahlungsheizquelle kontinuierlich unverbrauchtes Aufdampfgut nachgeliefert
     wird.

9.  Verfahren zum Aufdampfen von hochschmelzenden anorganischen Verbindungen in kontinuierlich betriebenen Vakuumbedampfungsanlagen, bestehend aus dem Aufdampfgut in
    fester Form und mindestens einer Strahlungsheizquelle,
    d a d u r c h   g e k e n n z e i c h n e t,
    daß ein doppeltes Aufdampfverfahren durchgeführt wird,
    derart,
    daß zuerst ein aus einem hochschmelzenden Metallband bestehendes Substrat bedampft und die darauf kondensierte
    Schicht mittels einer 2. Heizquelle auf das endgültige,
    aus einer Folie bestehende Substrat übertragen wird.

*Fig. 1*

0213556

0213556

Fig. 2

**Fig. 3**

**Fig. 4**

0213556

*Fig. 5*

**Fig. 6**